# EUROPÄISCHE PATENTSCHRIFT

(11) **EP 1 844 637 B1**
(45) Veröffentlichungstag und Bekanntmachung des Hinweises auf die Patenterteilung: **12.03.2008**
(21) Anmeldenummer: 05804961.0
(22) Anmeldetag: 05.12.2005
(51) Int. Cl.: H05K 7/20

(54) **ANORDNUNG ZUR KÜHLUNG VON ELEKTRONISCHEN MODULEINHEITEN IN GERÄTE -UND NETZWEKSCHRÄNKEN**
DEVICE FOR COOLING ELECTRONIC MODULAR UNITS IN DEVICE AND NETWORK CABINETS
DISPOSITIF POUR REFROIDIR DES UNITES MODULAIRES ELECTRONIQUES DANS DES ARMOIRES D'EQUIPEMENTS ET DE RESEAU

(30) Priorität: 04.02.2005 DE 102005005296
(43) Veröffentlichungstag der Anmeldung: 17.10.2007
(73) Patentinhaber: Knürr AG, 94424 Arnstorf (DE)
(72) Erfinder: KOCH, Peter, 86946 Vilgertshofen (DE); BRETSCHNEIDER, Rainer, 01662 Meissen (DE); EBERMANN, Heiko, 01109 Dresden (DE); WILLNECKER, Manfred, 94439 Rossbach (DE); FONFARA, Haralad, 94551 Lalling (DE); MILTKAU, Thorsten, 94469 Deggendorf (DE); KÜNKLER, Thomas, 94428 Eichendorf (DE); WEISSMANN, Lars, 91725 Ebingen (DE)
(74) Vertreter: Heim, Hans-Karl
(86) Internationale Anmeldenummer: PCT/EP2005/013023
(87) Internationale Veröffentlichungsnummer: WO 2006/081857

(56) Entgegenhaltungen:
- WO-A-01/72099
- DE-A1- 10 210 417
- DE-A1- 10 210 418
- DE-A1- 19 515 121
- DE-A1- 19 825 602
- DE-U1-2202004 006 55
- US-B1- 6 488 214
- US-B1- 6 819 563

## Beschreibung

Die Erfindung betrifft eine Anordnung zur Kühlung von elektronischen Moduleinheiten in Geräte- und Netzwerkschränken, insbesondere von Serverschränken., in einem Aufstellungsraum, gemäß dem Oberbegriff des Anspruchs 1.

Aus DE 195 15 121 C2 ist ein Gehäuseaufbau für im Freien aufstellbare elektrische und/oder elektronische Geräte bekannt. Der Outdoor-Gehäuseaufbau besteht aus einem Innenschrank und einem beabstandeten Außenschrank. Ein bodenseitig im Außenschrank angeordneter Kühlluft-Ventilator saugt einen Kühlluftstrom aus der Umgebung in den Außenschrank an, welcher obere Austrittsöffnungen aufweist. Ein Luft-Wärmetauscher im Innenschrank, welchem die Kühlluft aus dem Außenschrank zugeführt wird, und Umwälzventilatoren sorgen für einen im Kreislauf geführten Innenluftstrom. Außerdem sind die elektrischen- und elektronischen Geräte auf Kühlkörpern angeordnet, welche in Wanddurchbrüchen des Innenschrankes gehalten sind und mit dem Innenraum des Innenschrankes in Verbindung stehen.

In DE 102 10 418 A1 ist ein Schaltschrank mit einer als Rückwand ausgebildeten Kühleinrichtung beschrieben, welche einen Luft-Wasser-Wärmetauscher und Gebläse aufweist. Die Warmluft-Teilströme aus dem Innenraum des Schaltschrankes werden angesaugt und als gekühlte Luft über einen unter dem Innenraum angeordneten Lüftungskanal und eine Luft-Staukammer an der Frontseite dem Innenraum des Schrankes zurückgeführt.

Ein modulares Schaltschranksystem der DE 198 25 602 C2 ist mit einem Satz Türen versehen, welche jeweils wenigstens einen Lüfter aufweisen, austauschbar und zur Aufnahme eines Kühlmoduls, beispielsweise eines Kompressor-Kühlgerätes, eines Luft-Luft-Wärmetauschers oder eines Luft-Wasser-Wärmetauschers, entsprechend den Erfordernissen ausgebildet sind.

Aus DE 20 2004 006 552.5 U1 ist ein Geräte- und Netzwerkschrank, insbesondere Serverschrank, mit in einem Innenraum angeordneten elektronischen Moduleinheiten, insbesondere Servern, und einem im unteren Schrankbereich angeordneten Luft-Wasser-Wärmetauscher bekannt, welcher an die Kaltwasserversorgung des Gebäudes angeschlossen ist.

Durch eine Luftführung mit gleich langen Luftwegen und damit gleichen Strömungswiderständen für die einzelnen Moduleinheiten und durch eine lufttechnische Trennung zwischen der kalten Zuluft und erwärmten Abluft kann den einzelnen Moduleinheiten kalte Zuluft mit einer nahezu einheitlichen Zulufttemperatur zugeführt werden. Die Abführung der Verlustwärme der elektronischen Moduleinheiten, welche in einem Gehäuse mit Ventilator aufgenommen sind, erfolgt durch einen geschlossenen Kühlluftkreislauf, welcher einen über die Anordnung der elektronischen Moduleinheiten reichenden, insbesondere frontseitigen, Zuluftkanal für die im bodenseitigen Luft-Wasser-Wärmetauscher abgekühlte Zuluft und einen Abluftkanal aufweist, welcher hinter den elektronischen Moduleinheiten einen ersten Kanalabschnitt für eine aufsteigende Abluftströmung und einen zweiten Kanalabschnitt für eine absteigende Abluftströmung aufweist, welcher in der Rücktür des Schrankes angeordnet ist. Die Umlenkung der Abluftströmung erfolgt mit Hilfe von Ventilatoren im oberen Bereich der Rücktür, wobei vorteilhaft in der Rücktür ein rechter und ein linker absteigender Abluftkanal vorgesehen ist, durch welche die Abluft dem Luft-Wasser-Wärmetauscher zugeführt wird.

Aus US 6 819 563 B1 ist ein in einem Raum aufstellbarer Geräteschrank für übereinander angeordnete und mit einem Gebläse versehene elektronische Geräte beziehungsweise Bauteile bekannt. Bei diesem Indoor-Geräteschrank wird zur Kühlung der elektronischen Bauteile klimatisierte Raumluft zugeführt. Diese Raumluft wird mittels eines im Geräteschrank angeordneten Eingangs-Wärmetauschers, welcher mit Kühlwasser beaufschlagt wird, gekühlt, gelangt dann in die übereinander gestapelten elektronischen Geräte und wird als erwärmte Abluft in den Aufstellungsraum zurückgeführt. Zusätzlich kann ein Ausgangs-Wärmetauscher im Geräteschrank angeordnet sein, welcher die erwärmte Abluft abkühlt, bevor diese in die Umgebungsluft abgegeben wird.

Bei dem Geräteschrank der US 2004/0100770 A1 wird die Verlustwärme von übereinander angeordneten elektronischen Bauteilen mit Hilfe von Gebläsen und einer kombinierten Luft-Flüssigkeitskühlung abgeführt. An wenigstens einer Schrankseite sind ein Luft-Flüssigkeit-Wärmetauscher und die Gebläse in einem gesonderten Gehäuse montiert und mit dem Aufnahmeraum verbunden. Alternativ können Luft-Flüssigkeit-Wärmetauscher-Einheiten als Front- und Rücktür angeordnet sein. Ein geschlossener Kühlluftkreislauf wird durch Ausbildung eines Zuführungsbeziehungsweise Abführungsraums in den Türen sowie eines Verbindungsraums unter und/oder über der Stapelanordnung ermöglicht, wobei zusätzliche Ventilatoren im Zuführungs- und Abführungsraum angeordnet sein können. Die Wärmetauscher-Türen sind zwecks Zugang zum Aufnahmeraum und zu den elektronischen Bauteilen und Geräten am Schrankkorpus angelenkt.

In DE 102 10 417 B4 ist eine Anordnung zur Kühlung eines Schaltschrankes beschrieben, bei welcher die Verlustwärme von übereinander angeordneten, Wärme erzeugenden Einbauten mit Hilfe einer Wärmetauscher-Rückwand oder eines Rückwand-Wärmetauscher-Schrankes sowie eines Kühlluftstromes einer zentralen Kühlanlage abgeführt wird. Der Kühlluftstrom der zentralen Kühlanlage gelangt aus einem Doppelboden unterhalb des Schaltschrankes in einen insbesondere frontseitig ausgebildeten Zuluftschacht, und die erwärmte Abluft wird mit Hilfe von nachgeschalteten Ventilatoren in der Wärmetauscher-Rückwand bzw. im Rückwand-Wärmetauscher-Schrank mittels eines insbesondere Luft-Wasser-Wärmetauschers abgekühlt und entweder in den Doppelboden unterhalb des Schaltschrankes zurückgeführt oder aber an die Umgebungsluft des Schaltschrankes abgegeben. Die zentrale Kühlanlage versorgt sowohl die Umgebungsluft des Schaltschrankes als auch den Doppelboden und damit den Innenraum des Schaltschrankes mit Kühlluft, weshalb eine relativ aufwändige Regelung erforderlich ist, um die jeweils notwendige Kühlleistung zu erreichen.

Aus WO 01/72099 A2 und US 2001/0042616 A1 ist ein Kühlsystem für Geräte- und Netzwerkschränke bekannt, welches die Verlustwärme von leistungsstarken, dicht gepackten elektronischen Moduleinheiten in einer Vielzahl von aneinander gereihten Schränken in einem Aufstellungsraum flexibel und effektiv abführen soll. Das Kühlsystem soll die Raumklimatisierung ergänzen und kostengünstiger gestalten, indem die in einem Schrank erwärmte Abluft mittels Ventilatoren einem Luft-Fluid-Wärmetauscher zugeführt, auf Raumtemperatur abgekühlt und an die Umgebungsluft abgegeben wird. Die Ventilatoren und der Wärmetauscher sind in einem zusätzlichen Gehäuse untergebracht, welches an der Schrankrückseite befestigt wird. Die Abluft aus dem Schrank gelangt über eine Öffnung in der Schrankrückwand oder Schrankrücktür und eine komplementäre Öffnung in dem anliegenden Wärmetauscher-Ventilatoren-Gehäuse in den Innenraum dieses Gehäuses und wird dabei über den nahe der Gehäuseöffnung angeordneten Luft-Fluid-Wärmetauscher mittels der nachgeordneten Ventilatoren geführt und über die Außenwand des Gehäuses an die Umgebung abgegeben.

Gemäß einem Datenblatt der Anmelderin der WO 01/7209912 und US 2001/0042616 A1, Fa. Liebert, United States, Columbus, OH 43229: RackCooler, System Configuration Guide, Drawing Number 171439, Rev. 07, 6/12/2002, S. 1 bis 8 und dem zugehörigen Installation Manual, SL-16810 (9/01), S. 1 bis 10 wird der sogenannte "RackCooler", d.h. die Gehäuseeinheit mit einem Luft-Wasser-Wärmetauscher und übereinander angeordneten Ventilatoren, außenseitig an der Rücktür der Schränke befestigt, und das Kühlwasser, welches die aufgenommene Verlustwärme außerhalb des Schrankaufstellungsraumes abgibt, wird jedem RackCooler über ein bodenverlegtes Rohrsystem und Verbindungsschläuchen zwischen diesem Rohrsystem und jedem RackCooler zugeführt. Nachteile dieser Nachrüstung bestehender Türen sind Ausfallzeiten des Systems während der Nachrüstung, mögliche Überbelastungen der vorhandenen Verschluss- und Scharnierelemente, eine geringere Leistungsfähigkeit in Relation zum Raumbedarf wegen der Einschränkung der für die Kühlung zur Verfügung stehenden Räume infolge der Berücksichtigung der bestehenden Verschluss- und Scharniereinrichtung und ein relativ kleiner Öffnungswinkel der nachgerüsteten Tür.

Die Verbindungsschläuche, welche von bodenseitigen Anschlussstellen bis zu den Anschlüssen an jedem RackCooler reichen, müssen wegen der Anordnung der RackCooler an den Rücktüren relativ flexibel ausgebildet sein und der Schwenkbewegung der Türen folgen können. Damit sind die Nachteile verbunden, dass die Verbindungsschläuche nur eine mangelnde mechanische Stabilität und Robustheit und außerdem nicht die erforderliche Gasdichtheit aufweisen, so dass es aufgrund einer Gasdiffusion zu einer Korrosion der Rohre des Wärmetauschers kommen kann.

Der Erfindung liegt die **Aufgabe** zugrunde, eine Anordnung zur Kühlung von elektronischen Moduleinheiten in Geräte-und Netzwerkschränken, insbesondere Schrankreihen in einem Aufstellungsraum, zu schaffen, welche bei einer einfachen Konstruktion und stabilen Ausbildung die erforderliche Zugänglichkeit zum Aufnahmeraum und eine außerordentlich effiziente Abführung der Verlustwärme der elektronischen Moduleinheiten gewährleistet.

Erfindungsgemäß wird die Aufgabe durch die Merkmale des Anspruchs 1 gelöst. Zweckmäßige und vorteilhafte Ausgestaltungen sind in den Unteransprüchen und in der Figurenbeschreibung enthalten.

Ein Grundgedanke der Erfindung kann darin gesehen werden, eine rückseitige Kühlanordnung mit einem Luft-Fluid-Wärmetauscher und Ventilatoren derart auszubilden, dass eine Schwenkbewegung des Wärmetauschers bzw. der Wärmetauschereinheit und damit die Notwendigkeit flexibler Verbindungsschläuche entfallen kann und gleichzeitig ein Zugangsbereich an der Schrankrückseite gewährleistet ist. Unter einem Luft-Fluid-Wärmetauscher wird dabei ein Luft-Flüssigkeit-Wärmetauscher verstanden.

Erfindungsgemäß wird eine Anordnung mit einem Luft-Fluid-Wärmetauscher, insbesondere einem Luft-Wasser-Wärmetauscher, welcher an die Kaltwasserversorgung des Gebäudes angeschlossen ist und die Verlustwärme nach außerhalb des Schrankaufstellungsraumes abführt, von einer Ventilatoren-Anordnung, welche dem Luft-Fluid-Wärmetauscher die Abluft der elektronischen Moduleinheiten eines Schrankes zuführt, konstruktiv getrennt. Gemäß der Erfindung werden die Ventilatoren in eine Tür und vorzugsweise in eine Rücktür eines Schrankes integriert. Eine derart ausgebildete Ventilatoren-Tür reicht bevorzugt über die gesamte Höhe des Schrankes, zumindest über die Höhe des Aufnahmeraumes für elektronische Moduleinheiten, beispielsweise Server, und ermöglicht einen Zugriff auf die Server auch von der Rückseite. Ein derartiger rückseitiger Zugriff ist besonders vorteilhaft bei Anordnung von Blade-Servern, welche in der Regel nicht nach vorn, sondern nach hinten ausziehbar in einer Stapelanordnung aufgenommen sind.

Erfindungsgemäß ist der Luft-Fluid-Wärmetauscher konstruktiv getrennt von der Ventilatoren-Tür an der Rückseite des Schrankes unter Abdeckung eines Restbereiches der Schrankrückseite, d.h., zumindest des Bereiches, welcher nicht von der Ventilatoren-Tür abgedeckt wird, fest angeordnet.

Der Vorteil einer starren, zweckmäßigerweise demontierbaren Anordnung des Luft-Fluid-Wärmetauschers längsseitig und vorzugsweise vertikal neben der Ventilatoren-Tür und an diese angrenzend und vorzugsweise mittels Scharnieren verbunden, besteht darin, dass starre Rohre für die Verbindung des unter dem Flurboden verlegten Rohrsystems für die Kühlflüssigkeit mit jedem Luft-Fluid-Wärmetauscher eines Schrankes angeordnet werden können. Es müssen keine flexiblen Verbindungsschläuche mehr verwendet werden, da der Luft-Fluid-Wärmetauscher fest und nicht verschwenkbar an der Schrankrückseite befestigt ist. Die starren Rohre können aus einem gasdiffusionsdichten Material gefertigt sein, welche im Prinzip aus der Heizungstechnik bekannt sind. Indem eine Gasdiffusion im Bereich der Verbindungsrohre ausgeschlossen wird, besteht auch keine bzw. nur eine erheblich verringerte Korrosionsgefahr im Bereich des Wärmetauschers. Damit verbunden ist eine vorteilhafte längere Lebensdauer.

Es ist vorteilhaft, dass die Ventilatoren-Tür und der längsseitig angrenzende Luft-Fluid-Wärmetauscher als eine nachrüstbare Einheit ausgebildet sein und eine herkömmliche Schrankrückwand bzw. Schrankrücktür ersetzen können, wenn die Notwendigkeit einer wesentlich effizienteren Abführung der Verlustwärme besteht.

Die mögliche Nachrüstung eröffnet außerdem die vorteilhafte Möglichkeit, mit relativ geringen Investitions- und Betriebskosten eine Hochleistungskühlung, insbesondere in kommerziellen Rechenzentren mit bis zu 100 Schränken, einzelne Schränke gezielt mit der erfindungsgemäßen Ventilatoren-Tür und dem angrenzenden fest angeordneten Luft-Fluid-Wärmetauscher zu versehen. Dadurch kann die Bestückung der Schränke und auch die Belegung des Raumes mit derartigen Schränken bei gleichzeitiger Senkung der Kosten für die Raumklimatisierung optimiert werden.

Zweckmäßigerweise sind in der Ventilatoren-Tür Lüfter, vorzugsweise Radiallüfter, gleichmäßig beabstandet und insbesondere übereinander angeordnet und an einer Innenseite und Außenseite der gehäuseartigen Ventilatoren-Tür direkt oder indirekt befestigt. An der Innenseite der Ventilatoren-Tür sind zur Abführung der Abluft aus dem Aufnahmeraum des Schrankes komplementäre Öffnungen ausgebildet, und nach einer Umlenkung um ca. 90° gelangt die Luft durch eine wenigstens bereichsweise luftdurchlässige Verbindungsseite der Ventilatoren-Tür in den angrenzenden Luft-Fluid-Wärmetauscher. Eine Eintrittsseite des Wärmetauschergehäuses kann zweckmäßigerweise in gleicher Weise wie die Verbindungsseite der Ventilatoren-Tür luftdurchlässig bzw. perforiert ausgebildet sein, und eine parallele luftdurchlässig ausgebildete Austrittsseite des Wärmetauschergehäuses ermöglicht den Austritt der abgekühlten Luft in die Schrankumgebung.

Die Zuführung der Kühlluft aus der Umgebung der Schränke im Aufnahmeraum erfolgt in aller Regel im Bereich der frontseitigen Tür des Schrankes, und die insbesondere in einer Stapelanordnung angeordneten elektronischen Moduleinheiten können jeweils einen Ventilator in ihren Gehäusen aufweisen.

Die Ventilatoren-Tür ist sinnvollerweise über Scharniere an dem Wärmetauscher angelenkt und kann aus einer Schließstellung in eine Öffnungsstellung verschwenkt werden. Besonders vorteilhaft ist eine 180°- Öffnungsstellung, da diese einen vorteilhaften Zugang zu den elektronischen Moduleinheiten und zu dem Verkabelungsbereich an der Rückseite des Schrankes ermöglicht. Zweckmäßigerweise sind entsprechende Dichtungen im Bereich der Schrankrückseite und/oder der angrenzenden Ventilatoren-Tür sowie zwischen der Ventilatoren-Tür und dem Wärmetauschergehäuse angeordnet, um in Betriebsstellung, d.h. mit geschlossener Ventilatoren-Tür, eine effiziente Abführung der erwärmten Abluft, deren Kühlung und Abgabe an die Umgebungsluft zu gewährleisten.

Es ist vorteilhaft, dass die Ventilatoren-Tür und/oder der Luft-Fluid-Wärmetauscher für unterschiedlich breite Schränke sowie für unterschiedlich breite rückseitige Zugangsbereiche ausgebildet sein können. Für Schränke mit einer Breite von etwa 750 mm und einer Wärmetauschereinheit mit einer Breite von etwa 210 mm kann durch eine seitlich überstehende Anordnung des Wärmetauschers ein Zugangsbereich von etwa 665 mm Breite erreicht werden. Wenn angrenzend an die Schließseite der Ventilatoren-Tür die Außenseite der Ventilatoren-Tür abgeschrägt ausgebildet ist, wird eine vorteilhafte Schwenkbewegung der rückseitigen Ventilatoren-Tür des angrenzenden Schrankes ermöglicht.

Von Vorteil ist weiterhin, dass für einen Schrank, welcher beispielsweise eine Breite von 600 mm aufweist und welcher bevorzugt für Blade-Server vorgesehen ist, die gleiche Wärmetauschereinheit an der Rückseite des Schrankes und insbesondere fluchtend mit einer Seitenwand befestigt werden kann. Die VentilatorenTür weist dann eine geringere Breite, beispielsweise von etwa 350 bis 400 mm auf, welche jedoch für eine Betätigung der Blade-Server von der Rückseite her ausreicht. Die Ventilatoren-Tür kann an dem Wärmetauscher über Scharniere an der Außenwand angelenkt und über eine vertikale Schwenkachse um 180° in eine Öffnungsstellung verschwenkt werden. Die übereinander angeordneten Ventilatoren sind im Bereich von beispielsweise düsenartigen Einführöffnungen an der Innenseite der Tür befestigt und reichen bevorzugt bis zu der Außenwand der Ventilatoren-Tür, wobei hier eine Abstandshalterung vorgesehen sein kann. Die Schließvorrichtung der Ventilatoren-Tür ist zweckmäßigerweise der Türausbildung angepasst und an der der Wärmetauscherseite gegenüber liegenden Schließseite der Ventilatoren-Tür vorgesehen.

Es liegt im Rahmen der Erfindung, weitere Ausbildungsvarianten für die erfindungsgemäße Anordnung eines starr befestigten Luft-Fluid-Wärmetauschers und einer als Ventilatoren-Tür ausgebildeten Ventilatoren-Anordnung vorzusehen. Beispielsweise kann die Ventilatoren-Tür an ihrer dem Wärmetauscher gegenüberliegenden Seite an der Schrankrückwand angelenkt werden. Die Schließseite der Tür wäre dann an der Wärmetauscherseite. Die Vorteile einer derartigen Ausbildung bestehen darin, dass die Ventilatoren-Tür von der Wärmetauschereinheit nicht getragen werden muss und die Lasten symmetrisch auf den nachzurüstenden Schrank verteilt werden. Es kann des weiteren erwartet werden, dass die Abdichtung an der Fügestelle zwischen der Ventilatoren-Tür und dem Wärmetauschermodul besser beherrschbar ist, indem die Dichtheit bei einer nachlassenden Vorspannung der Dichtung nicht vom Drehwinkel abhängig ist und außerdem der Anpressdruck durch die Schließeinrichtung beeinflusst werden kann. Weiterhin ist es vorteilhaft, dass bei einer derartigen konstruktiven Ausbildung der freie Strömungsquerschnitt zwischen der Ventilatoren-Tür und der Wärmetauschereinheit größer ausgebildet werden kann, was mit geringeren Druckverlusten verbunden ist.

In einer Abwandlung kann die Scharnierung der Ventilatoren-Tür an einer zusätzlichen Konstruktion angeordnet werden, so dass die Schwenkachse beabstandet von der Rückseite des Schrankes angeordnet ist. Indem der Drehpunkt der Ventilatoren-Tür beabstandet zur Schrankrückseite festgelegt wird, ergeben sich größere Freiheitsgrade hinsichtlich des Öffnungswinkels der Ventilatoren-Tür.

In einer Weiterbildung der Erfindung kann vorgesehen sein, dass der Wärmetauscher starr angeordnet ist, jedoch sein Gehäuse, zumindest teilweise, schwenkbar ausgebildet ist. Damit können die Nachteile einer verschwenkbaren Anordnung des Wärmetauschers vermieden werden. Gleichzeitig kann das Wärmetauschermodul mit einer Wärmetauscher-Tür versehen sein, welche an einer vertikalen Schwenkachse angelenkt ist und einen Zugang zu dem Wärmetauscher ermöglicht. Die Trennebene zwischen der Ventilatoren-Tür und der Wärmetauscher-Tür wird von der Anordnung und dem Platzbedarf der Ventilatoren sowie des Wärmetauschers bestimmt. Indem beide Türen um seitliche und gegenüberliegende Drehachsen verschwenkbar sind, kann eine vorteilhafte Abdichtung im Bereich der aneinander grenzenden Trenn- bzw. Dichtebene durchgeführt werden. Außerdem ist ein vorteilhafter größerer Zugang zu dem Schrank von der Rückseite möglich, wenn beide Türen geöffnet sind.

Eine starre Anordnung wenigstens eines Wärmetauschers und eine verschwenkbare Ventilatoren-Tür kann in einer weiteren Variante auch dadurch erreicht werden, dass die Schrankrückseite zwei Türhälften aufweist und sich in jeder Türhälfte Ventilatoren und ein Wärmetauscher befinden. Jeder Wärmetauscher ist dabei erfindungsgemäß starr angeordnet und jede Tür bzw. Halbtür mit den Ventilatoren, beispielsweise zwei Ventilatoren, ist um eine Achse, z.B. im Bereich des Wärmetauschers, schwenkbar angelenkt. Auch diese konstruktive Variante ermöglicht einen guten Zugang zum Schrank. Weiterhin ist eine Redundanz gegeben, indem die Trennebene zwischen den Türhälften frei ist, so dass die Lüfter auf beide Wärmetauscher wirken können. Es wird eine gleichmäßige Wärmeabführung an der Rückseite der angeordneten elektronischen Moduleinheiten bei geöffneten Türen erreicht.

In einer Ausgestaltung können der wenigstens eine Wärmetauscher und die Ventilatoren in einem Türflügel angeordnet sein, welcher im Wesentlichen die gesamte Rückseite des Schrankes abdeckt. Der Wärmetauscher ist starr befestigt und die Ventilatoren-Tür ist um eine Längsachse verschwenkbar angeordnet. Wesentliche zusätzliche Vorteile dieser Anordnung sind ein guter Zugang von der Schrankrückseite und eine Kühlleistung auch bei geöffneten Türen.

Die erfindungsgemäße Kühlungsanordnung ist bevorzugt für eine Luftführung vorgesehen, bei welcher Abluft aus dem Aufnahmeraum des Schrankes in die Ventilatoren-Tür und danach in den fest installierten Wärmetauscher gelangt. Es liegt im Rahmen der Erfindung, die Abluftströmung aus dem Schrank zuerst durch den Wärmetauscher zu führen und dann über die Ventilatoren-Tür an die Umgebung abzugeben.

Ein vorteilhafter ästhetischer Gesamteindruck ergibt sich, wenn das Wärmetauschergehäuse und die Ventilatoren-Tür zumindest im Bereich der Ventilatoren-Anordnung nahezu die gleiche Tiefe aufweisen.

Die wesentlichen Vorteile der erfindungsgemäßen Kühlungsanordnung sind die Nachrüstbarkeit und die durch die starre Befestigung der Wärmetauschereinheit ermöglichte Verwendung von gasdichten und starren Verbindungsrohren für das Kühlmedium.

Aufgrund der starren Anordnung des Wärmetauschers besteht außerdem die vorteilhafte Möglichkeit, dass die Schnittstelle zu unterschiedlichen Schrankkonstruktionen starr ausgeführt werden kann, beispielsweise mittels Schraubverbindungen, und die für die Schwenkbewegung des beweglichen Teils, insbesondere der Ventilatoren-Tür erforderlichen Scharniere, Drehlager können für alle Schrankarten und -größen einheitlich ausgeführt werden. Damit wird die Nachrüstung bestehender Geräte- oder Netzwerkschränke wesentlich vereinfacht.

Die Erfindung wird nachstehend anhand einer Zeichnung weiter beschrieben; in dieser zeigen:
- Fig. 1: eine Ansicht der Rückseite eines Geräte- und Netzwerkschrankes mit der erfindungsgemäßen Anordnung;
- Fig. 2: einen Längsschnitt gemäß Linie II-II des Geräte- und Netzwerkschrankes der Fig. 4;
- Fig. 3: einen Längsschnitt gemäß Linie III-III des Geräte- und Netzwerkschrankes nach Fig. 4;
- Fig. 4: einen Querschnitt der erfindungsgemäßen Anordnung und des rückseitigen Bereiches des Geräte- und Netzwerkschrankes nach Fig. 1 in Schließstellung;
- Fig. 5: einen Querschnitt analog zu Fig. 4, jedoch in Öffnungsstellung der erfindungsgemäßen Anordnung;
- Fig. 6: eine Ansicht auf die Rückseite eines Geräte- und Netzwerkschrankes mit einer alternativen erfindungsgemäßen Anordnung;
- Fig. 7: einen Querschnitt der erfindungsgemäßen Anordnung und des rückseitigen Bereiches des Geräte- und Netzwerkschrankes nach Fig. 6 in Schließstellung;
- Fig. 8: einen Querschnitt analog zu Fig. 7, jedoch in Öffnungsstellung der erfindungsgemäßen Anordnung;
- Fig. 9 bis 13: in stark schematisierter Weise alternative Ausbildungen der erfindungsgemäßen Anordnung.

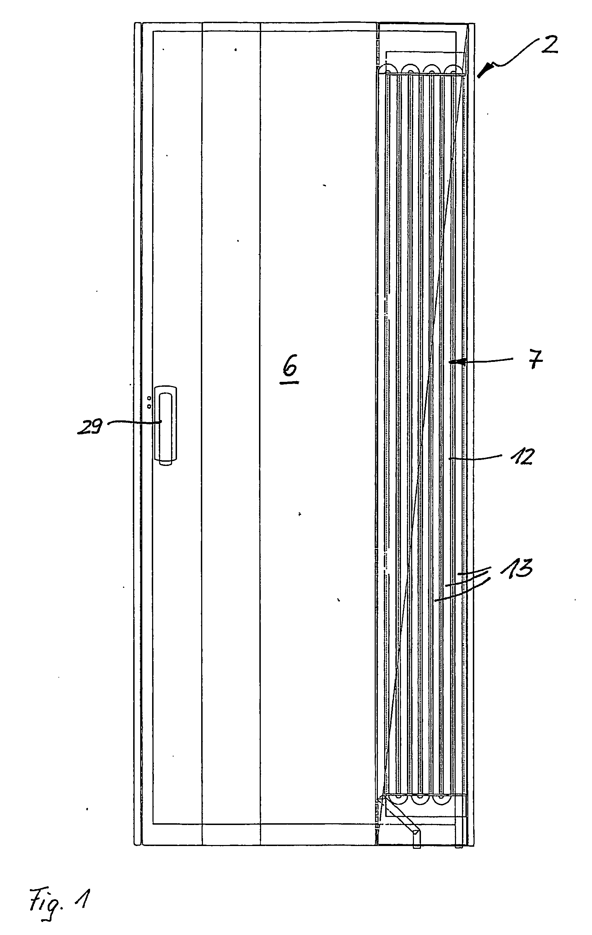

In den Fig. 1 bis 5 ist ein Schrank 2, insbesondere ein Serverschrank, mit der erfindungsgemäßen Kühlungsanordnung an der Rückseite des Schrankes 2 gezeigt. Zur Kühlung der in einem Aufnahmeraum 3 für elektronische Moduleinheiten, insbesondere für in einer Stapelanordnung angeordnete Server (nicht dargestellt), sind im Bereich der Rückseite des Schrankes eine Ventilatoren-Tür 6 und ein Luft-Fluid-Wärmetauscher 7 angeordnet, welche längsseitig aneinander grenzend und über die gesamte Schrankhöhe reichend eine herkömmliche rückseitige Wand oder Rücktür ersetzen.

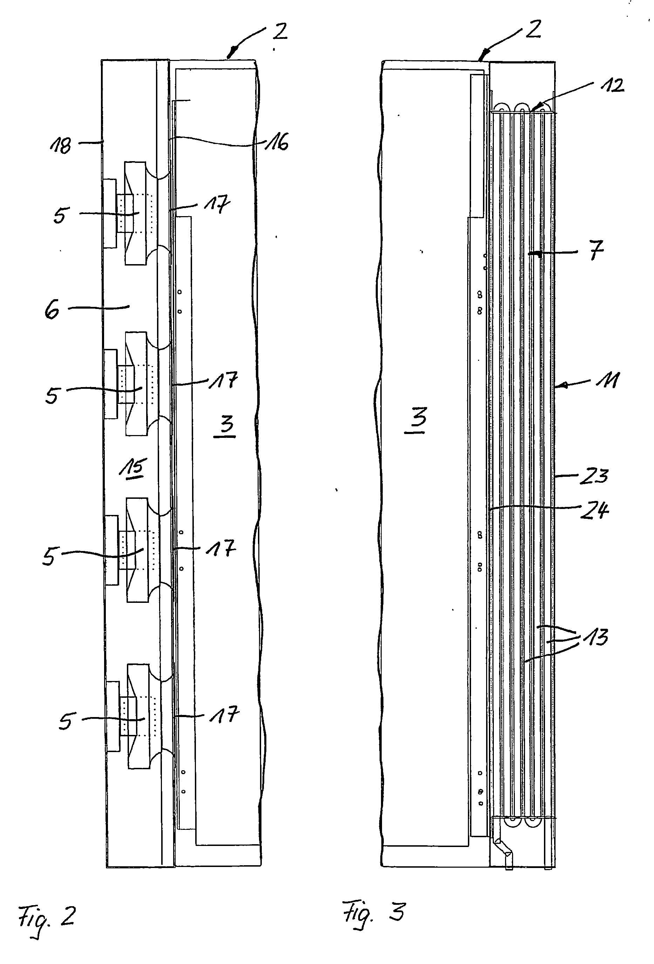

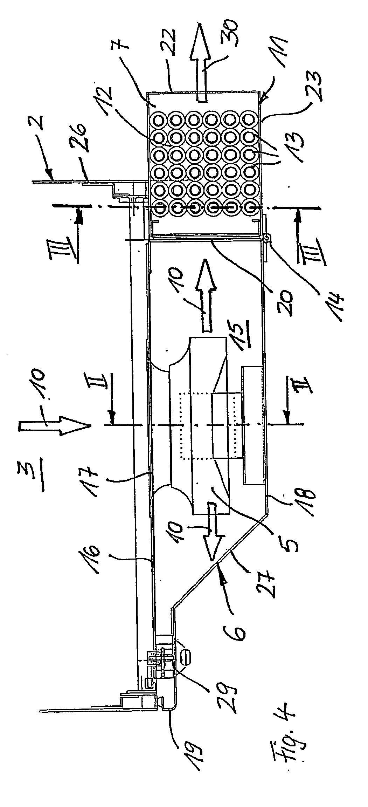

Die Ventilatoren-Tür 6 weist in diesem Ausführungsbeispiel vier übereinander angeordnete Ventilatoren 5 auf (siehe Fig. 2), welche von einer Innenseite 16 bis zu einer Außenseite 18 der Ventilatoren-Tür 6 reichen und Abluft 10 aus dem Aufnahmeraum 3 des Schrankes 2 über Öffnungen 17 in der Innenseite 16 ansaugen und einer etwa 90°-Umlenkung unterziehen (siehe auch Fig. 4). Die Abluft 10 gelangt dadurch in einen Abluftraum 15 der Ventilatoren-Tür 6, welcher von der Innen- und Außenseite 16, 18 sowie von einer Schließseite 19 und einer Verbindungsseite 20 gebildet wird. An der Schließseite 19 ist eine Schließeinrichtung 29 vorgesehen, mit welcher die Ventilatoren-Tür 6 in der in Fig. 4 gezeigten Betriebsstellung verschlossen werden kann. Der Aufnahmeraum 15 der Ventilatoren-Tür 6 steht über eine abgedichtete und wenigstens bereichsweise luftdurchlässige bzw. perforiert ausgebildete Verbindungsseite 20 mit dem Luft-Fluid-Wärmetauscher 7 in Verbindung, wobei eine luftdurchlässig bzw. perforiert ausgebildete Eintrittsseite 21 eines Wärmetauschergehäuses 11 unmittelbar an die Verbindungsseite 20 der Ventilatoren-Tür 6 angrenzt (siehe Fig. 4). Die in den Wärmetauscher 7 gelangende Abluft 10 wird entwärmt und über eine Austrittsseite 22, welche parallel zur Eintrittsseite 21 ausgebildet ist, als abgekühlte Abluft 30 in die Umgebungsluft des Aufstellungsraumes der Schränke 2, vorzugsweise mit Umgebungstemperatur, abgegeben.

Indem die Ventilatoren 5 gleichmäßig beabstandet und über die gesamte Schrankhöhe bzw. die Höhe des Aufnahmeraumes 3 reichend angeordnet sind (siehe Fig. 2) wird eine effiziente und den jeweiligen Erfordernissen anpassbare Abluftentwärmung gewährleistet. Der Luft-Fluid-Wärmetauscher 7, welcher in diesem Ausführungsbeispiel ein Lamellen-Wärmetauscher ist und ein Rohr-Lamellen-Paket 12 aus vertikal ausgerichteten Rohren 13, beispielsweise Kupferrohren und Kühllamellen, aufweist, ermöglicht durch den Anschluss an die Kühlwasserversorgung des Gebäudes eine Abführung der Verlustwärme nach außerhalb des Schrankaufnahmeraums.

Da der Wärmetauscher 7 mit seinem Wärmetauschergehäuse 11 fest, jedoch demontierbar im Bereich der Rückseite des Schrankes 2 angeordnet und nicht in die Schwenkbewegung der Ventilatoren-Tür 6 einbezogen ist, können starre Verbindungsrohre zwischen dem Wärmetauscher 7 und den gebäudeseitigen Rohrsystem der Kaltwasserversorgung eingesetzt werden (nicht dargestellt). Derartige starre Verbindungsrohre sind gasdicht ausgebildet und verhindern eine Korrosion der Rohre 13, welche bei den für verschwenkbar angeordnete Wärmetauscher erforderlichen flexiblen Verbindungsschläuchen in der Regel unausweichlich ist.

Die Anlenkung der Ventilatoren-Tür 6 an dem fest angeordneten Luft-Fluid-Wärmetauschers 7 erfolgt mittels Scharnieren 14, welche im Bereich der Außenseite 18 der Ventilatoren-Tür 6 und der Außenwand 23 des Wärmetauschergehäuses 11 angeordnet sind und eine Verschwenkung um eine vertikale Schwenkachse 25 gewährleisten.

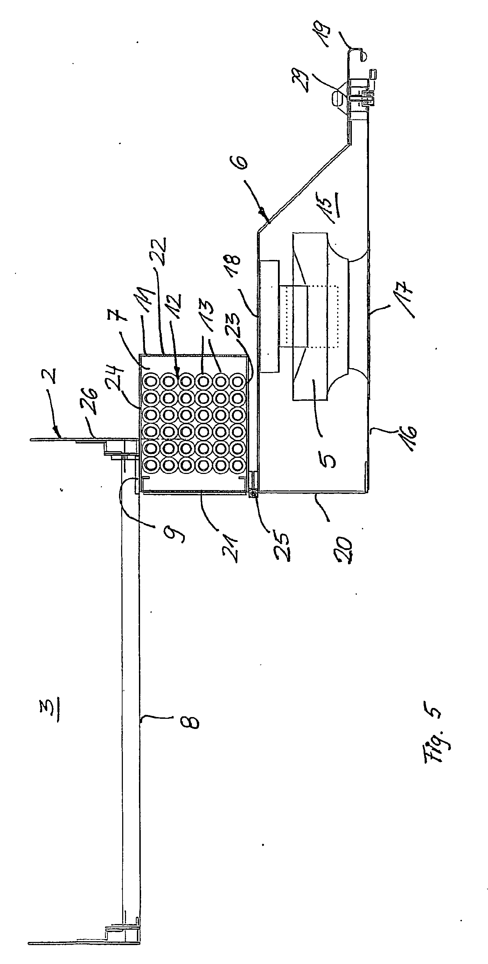

Der Schrank der Fig. 1 bis 5 weist eine Breite von etwa 750 mm auf und die Ventilatoren-Tür 6 ist zwischen der Schließeinrichtung 29 und den Ventilatoren 5 mit einer Abschrägung 27 versehen. Diese Abschrägung ist für eine großzügige Öffnungsstellung (siehe Fig. 5) mit Zugang über einen Zugangsbereich 8 vorteilhaft. Der relativ breite Zugangsbereich 8 wird auch durch eine überstehende Anordnung des Luft-Fluid-Wärmetauschers 7 erreicht (siehe Fig. 4 und 5). Ein benachbarter Schrank ist dann entsprechend beabstandet angeordnet, und die abgeschrägte Ausbildung der Ventilatoren-Tür 6 ermöglicht einen Zugang auch zu einem benachbarten Schrank, selbst wenn die Ventilatoren-Türen 6 beider Schränke gemäß Fig. 5 geöffnet sind.

Der überstehende Luft-Fluid-Wärmetauscher 7 deckt nur einen relativ schmalen Restbereich 9 der Rückseite des Schrankes 2 ab.

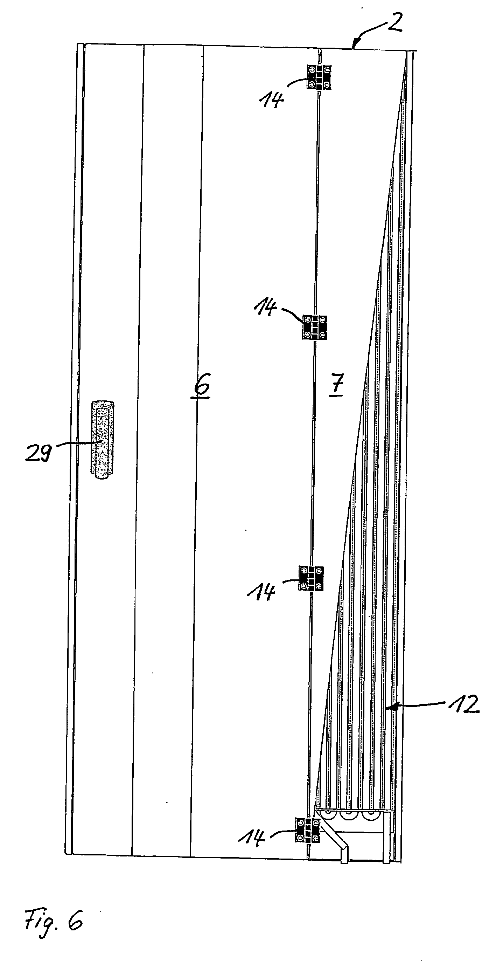

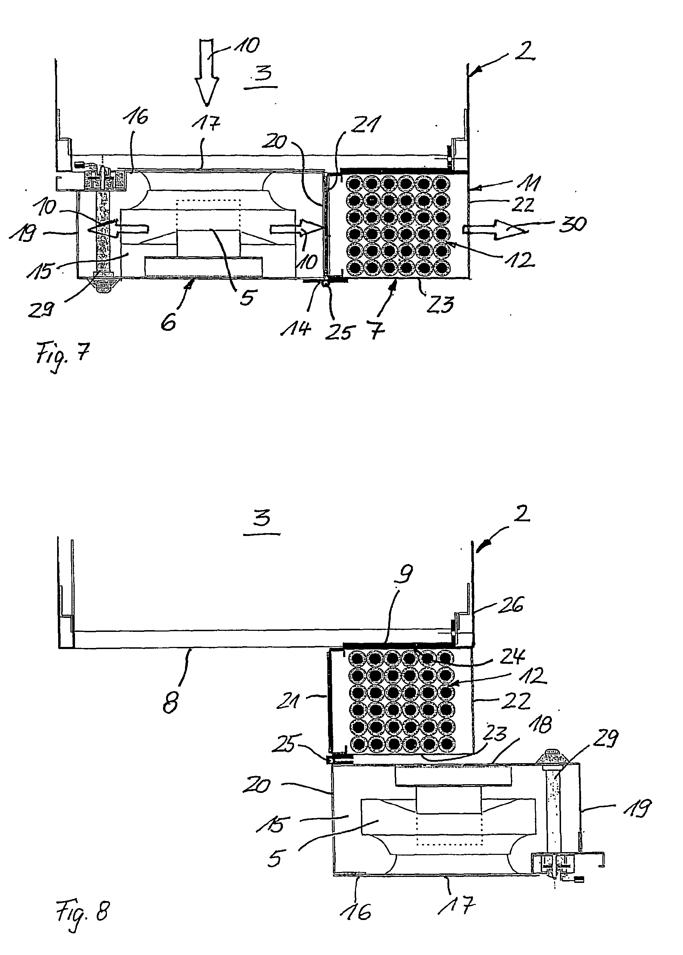

Bei einer alternativen Anordnung, welche in den Fig. 6 bis 8 gezeigt ist, ist der im Wesentlichen identisch ausgebildete Luft-Fluid-Wärmetauscher 7 bündig zu einer Seitenwand 26 des Schrankes 2 angeordnet (siehe Fig. 7 und 8). Der Wärmetauscher 7 deckt damit einen breiteren Restbereich 9 der Rückseite des Schrankes 2 ab, und ein zugangsbereich 8, welcher durch eine Ventilatoren-Tür 6 in Schließstellung verschlossen ist, ist schmaler ausgebildet. Dieser Zugangsbereich 8 ermöglicht jedoch das Herausziehen der elektronischen Moduleinheiten bei geöffneter Ventilatoren-Tür 6 gemäß Fig. 8, insbesondere wenn es sich dabei um Blade-Server handelt (nicht dargestellt).

Auch in der Ventilatoren-Tür 6 des Schrankes 2 der Fig. 6 bis 8 sind vier Ventilatoren 5 übereinander angeordnet und saugen die Abluft 10 aus dem Aufnahmeraum 3 in den Türabluftraum 15. Nach einer etwa 90°-Umlenkung gelangt die Abluft 10 in den Wärmetauscher 7 und wird nach Abkühlung mittels in den Rohren 13 geführter Kühlflüssigkeit, insbesondere Kühlwasser, über eine Austrittsseite 22 an die Umgebung abgegeben.

In den Fig. 6 bis 8 wurden für identische Merkmale identische Bezugszeichen verwendet. Die als eine modulartige Einheit herstellbare Kühlungsanordnung aus einer verschwenkbaren Ventilatoren-Tür 6 und einem fest angeordneten Wärmetauscher 7 können eine Rückseite bzw. Rücktür eines Schrankes ersetzen. Die Ventilatoren-Tür 6 der Fig. 6 bis 8, welche schmaler als die der Fig. 1 bis 5 ist, weist eine entsprechend angepasste Schließeinrichtung 29 auf und kann um eine vertikale Schwenkachse 25 ebenfalls in eine um 180° verschwenkte Öffnungsstellung (Fig. 8) gebracht werden.

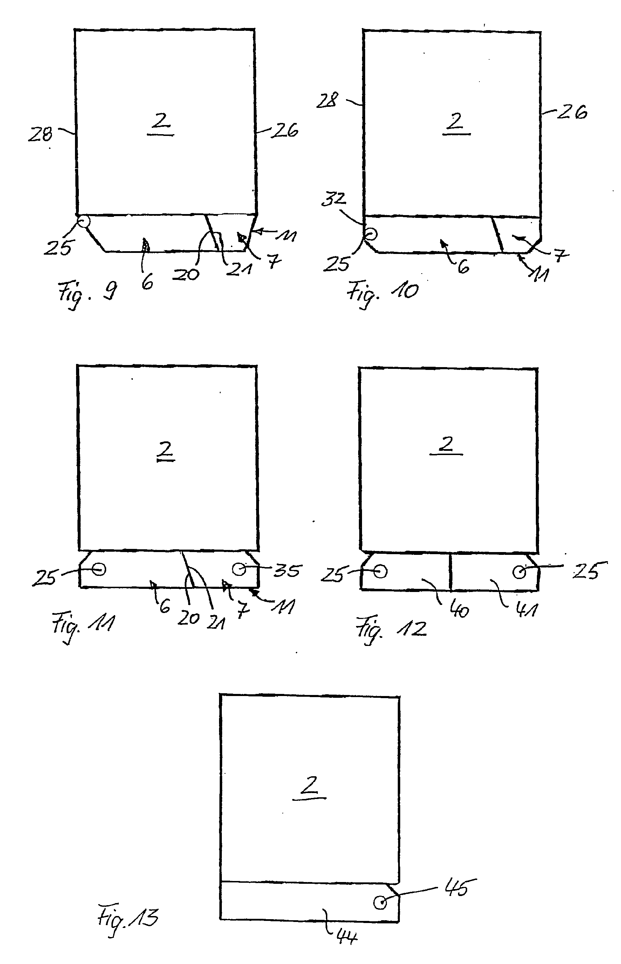

Die Fig. 9 bis 13 zeigen alternative Ausbildungen zur Anordnung der nachrüstbaren Kühlungsanordnung. In Fig. 9 ist die Ventilatoren-Tür 6 im Unterschied zu den Fig. 6 bis 8 nicht an dem Luft-Fluid-Wärmetauscher 7 bzw. an dem Wärmetauschergehäuse 11, sondern rückseitig am Schrank 2 angelenkt. Die Ventilatoren-Tür 6 und der Luft-Fluid-Wärmetauscher 7 erstrecken sich über die Rückseite des Schrankes 2, und die Verbindungsseite 20 der Ventilatoren-Tür 6 ist komplementär zu der Eintrittsseite 21 des Wärmetauschergehäuses 11 abgeschrägt ausgebildet, wodurch der Querschnitt für den Luftübergang vergrößert wird.

Fig. 10 zeigt eine Ventilatoren-Tür 6, die an der dem Luft-Fluid-Wärmetauscher 7 gegenüberliegenden Seite angelenkt ist. Die Schwenkachse 25 ist jedoch nicht direkt am Schrank 2 bzw. im Bereich einer Seitenwand 28 des Schrankes 2 angeordnet, sondern befindet sich an einer Hilfskonstruktion 32, z.B. der Seitenwand 28, und damit im Abstand von der Rückseite des Schrankes. Aufgrund des sich daraus ergebenden größeren Öffnungswinkels ist eine bessere Zugänglichkeit zum Schrank gegeben.

In Fig. 11 sind die Ventilatoren-Tür 6 um die außenseitig angeordnete Schwenkachse 25 und das Wärmetauschergehäuse 11 um die gegenüberliegende vertikale Schwenkachse 35 nach außen verschwenkbar, so dass die Zugangsbreite nahezu unbeschränkt ist. Im Bereich der aneinandergrenzenden Verbindungsseite 20 und Eintrittsseite 21 ist eine entsprechende Abdichtung vorgesehen, welche vorteilhaft von der hier anzuordnenden Schließeinrichtung (nicht dargestellt) unterstützt werden kann.

In Fig. 12 ist eine Weiterbildung gezeigt, bei welcher die erfindungsgemäße Anordnung von Ventilatoren und starr angeordnetem Wärmetauscher (nicht dargestellt) jeweils in einer linken Tür 40 und einer rechten Tür 41 realisiert ist, welche beispielsweise, wie dargestellt, als Türhälften ausgebildet sein können. Jedem Wärmetauscher kann die Abluft aus dem Schrank 2 mittels Ventilatoren (nicht dargestellt) in jeder Tür 40, 41 zugeführt werden, womit eine besonders gleichmäßige Wärmeabführung erreicht wird.

Bei der alternativen Ausbildung gemäß Fig. 13 ist nur eine Tür 44 an der Rückseite des Schrankes 2 vorgesehen. Im Bereich dieser Tür 44, welche um eine Schwenkachse 45 in eine Öffnungsstellung gebracht werden kann, ist wiederum ein Wärmetauscher (nicht dargestellt) starr untergebracht, und mit der Tür 44 werden lediglich die darin angeordneten Ventilatoren verschwenkt.

## Patentansprüche

1. Anordnung zur Kühlung von elektronischen Moduleinheiten in Geräte- und Netzwerkschränken, insbesondere Serverschränken, in einem Aufstellungsraum,
mit einer frontseitigen Zuführung von Kühlluft aus der Umgebung des Schrankes (2), mit einem Luft-Flüssigkeit-Wärmetauscher (7) und mit Ventilatoren (5), welche im Bereich einer Rückseite des Schrankes (2) zur Abführung der von den elektronischen Moduleinheiten entwickelten Verlustwärme angeordnet sind und die mit der Verlustwärme beaufschlagte Abluft (10) der elektronischen Moduleinheiten aus dem Schrank (2) absaugen und vor Abgabe in die Umgebungsluft des Schrankes (2) zur Entwärmung durch den Luft-Flüssigkeit-Wärmetauscher (7) leiten,
**dadurch gekennzeichnet,**
**dass** die Ventilatoren (5) in eine Tür integriert sind und eine Ventilatoren-Tür (6) gebildet ist, welche in Schließstellung einen Zugangsbereich (8) der Rückseite des Schrankes (2) abdeckt, und
**dass** der Luft-Flüssigkeit-Wärmetauscher (7) längsseitig an die Ventilatoren-Tür (6) angrenzend und einen Restbereich (9) der Rückseite des Schrankes (2) abdeckend angeordnet ist.

2. Anordnung nach Anspruch 1,
**dadurch gekennzeichnet,**
**dass** als Ventilatoren (5) Radiallüfter in der Ventilatoren-Tür (6) angeordnet sind und dass die Abluft (10) aus dem Schrank (2) nach einer 90°-Umlenkung innerhalb der Ventilatoren-Tür (6) dem angrenzenden Luft-Flüssigkeit-Wärmetauscher (7) zuführbar ist.

3. Anordnung nach Anspruch 1 oder 2,
**dadurch gekennzeichnet,**
**dass** die Ventilatoren-Tür (6) an dem Luft-Flüssigkeit-Wärmetauscher (7) angelenkt ist und aus einer Schließstellung bis zu 180° in eine Öffnungsstellung verschwenkbar ist.

4. Anordnung nach einem der vorhergehenden Ansprüche,
**dadurch gekennzeichnet,**
**dass** die Kühlflüssigkeit des Luft-Flüssigkeit-Wärmetauschers (7) die aufgenommene Verlustwärme außerhalb des Schrankaufstellungsraumes abgibt.

5. Anordnung nach einem der vorhergehenden Ansprüche,
**dadurch gekennzeichnet,**
**dass** als Luft-Flüssigkeit-Wärmetauscher (7) ein Luft-Wasser-Wärmetauscher angeordnet ist.

6. Anordnung nach einem der vorhergehenden Ansprüche,
**dadurch gekennzeichnet,**
**dass** der Luft-Flüssigkeit-Wärmetauscher (7) ein Rohr-Lamellen-Paket (12) mit vertikal ausgerichteten Rohren (13) für die Kühlflüssigkeit, insbesondere für Kaltwasser aus der Kaltwasserversorgung des Gebäudes, in einem Wärmetauschergehäuse (11) aufweist.

7. Anordnung nach einem der vorhergehenden Ansprüche,
**dadurch gekennzeichnet,**
**dass** die Ventilatoren-Tür (6) gehäuseartig ausgebildet ist und eine Innenseite (16) mit Öffnungen (17) für die aus dem Schrank (2) abzusaugende Abluft (10), eine Außenseite (18), welche wenigstens im Bereich der Ventilatoren (5) parallel zu der Innenseite (16) angeordnet ist, eine Schließseite (19) und parallel zu dieser eine Verbindungsseite (20) aufweist, welche an eine Eintrittsseite (21) des Wärmetauschergehäuses (11) angrenzt und wie diese wenigstens bereichsweise perforiert ausgebildet ist.

8. Anordnung nach einem der vorhergehenden Ansprüche,
**dadurch gekennzeichnet,**
**dass** das Wärmetauschergehäuse (11) gegenüber der Eintrittsseite (21) eine Austrittsseite (22) aufweist, durch welche die im Luft-Flüssigkeit-Wärmetauscher (7) auf etwa Umgebungstemperatur gekühlte Abluft (30) austritt.

9. Anordnung nach einem der vorhergehenden Ansprüche,
**dadurch gekennzeichnet,**
**dass** die Ventilatoren-Tür (6) für unterschiedlich breite Schränke (2) und/oder unterschiedlich breite rückseitige Zugangsbereiche (8) ausgebildet ist.

10. Anordnung nach einem der vorhergehenden Ansprüche,
**dadurch gekennzeichet,**
dass der Luft-Flüssigkeit-Wärmetauscher (7) demontierbar im rückseitigen Bereich des Schrankes (2) befestigt ist.

11. Anordnung nach einem der vorhergehenden Ansprüche,
**dadurch gekennzeichnet,**
**dass** der Luft-Flüssigkeit-Wärmetauscher (7) fluchtend mit einer Seitenwand (26) des Schrankes (2) oder über die Seitenwand (26) des Schrankes (2) überstehend angeordnet ist.

12. Anordnung nach einem der vorhergehenden Ansprüche,
**dadurch gekennzeichnet,**
**dass** die Ventilatoren-Tür (6) mit Hilfe von Scharnieren (14), welche an der Außenseite (18) der Ventilatoren-Tür (6) und einer Außenwand (23) des Wärmetauschergehäuses (11) angeordnet sind, um eine vertikale Achse (25) verschwenkbar ist.

13. Anordnung nach einem der vorhergehenden Ansprüche,
**dadurch gekennzeichnet,**
**dass** das Rohr-Lamellen-Paket (12) des Luft-Flüssigkeit-Wärmetauschers (7) über Verbindungsschläuche, welche aus einem gasdiffusionsdichten Werkstoff bestehen, mit der Kaltwasserversorgung des Gebäudes verbunden sind.

14. Anordnung nach einem der vorhergehenden Ansprüche,
**dadurch gekennzeichnet,**
**dass** in der Ventilatoren-Tür (6) mehrere Ventilatoren (5) über- und/oder nebeneinander angeordnet und an der Innen- und Außenseite (16, 18) befestigt sind.

15. Anordnung nach einem der vorhergehenden Ansprüche,
**dadurch gekennzeichnet,**
**dass** der Luft-Flüssigkeit-Wärmetauscher (7) wie die Ventilatoren-Tür (6) über die Höhe des Schrankes (2), zumindest über die Höhe des Aufnahmeraumes (3) reicht.

16. Anordnung nach einem der vorhergehenden Ansprüche,
**dadurch gekennzeichnet,**
**dass** die Ventilatoren-Tür (6) und der Luft-Flüssigkeit-Wärmetauscher (7) als Nachrüsteinheiten ausgebildet sind.

17. Anordnung nach einem der Ansprüche 1, 2, 4 bis 16,
**dadurch gekennzeichnet,**
**dass** die Ventilatoren-Tür (6) an dem Schrank (2) angelenkt ist und aus einer Schließstellung in eine Öffnungsstellung bis zu 180° verschwenkbar ist.

18. Anordnung nach Anspruch 17,
**dadurch gekennzeichnet,**
**dass** die Ventilatoren-Tür (6) mit einer abgeschrägten Verbindungsseite (20) abgedichtet an einer Eintrittsseite (21) des Wärmetauschergehäuses (11) anliegt.

19. Anordnung nach Anspruch 17 oder 18,
**dadurch gekennzeichnet,**
**dass** die Schwenkachse (25) an einer Hilfskonstruktion (32) des Schrankes (2) angeordnet ist.

20. Anordnung nach einem der Ansprüche 17 bis 19,
**dadurch gekennzeichnet,**
**dass** der Luft-Flüssigkeit-Wärmetauscher (7) starr an der Rückseite des Schrankes (2) angeordnet ist und das Wärmetauschergehäuse (11) um eine Schwenkachse (35) in eine Öffnungsstellung bringbar ist.

21. Anordnung nach einem der Ansprüche 17 bis 20,
**dadurch gekennzeichnet,**
**dass** an der Rückseite des Schrankes (2) zwei Ventilatoren-Türen (40, 41) vorgesehen sind, in deren Bereich jeweils ein Wärmetauscher angeordnet ist, und welche über Schwenkachsen (25) in eine Öffnungsstellung bringbar sind.

22. Anordnung nach einem der Ansprüche 17 bis 21,
**dadurch gekennzeichnet,**
**dass** an der Rückseite des Schrankes (2) eine Ventilatoren-Tür (44) vorgesehen ist, welche über die gesamte Rückseite reicht und um eine Schwenkachse (45) in eine Öffnungsstellung bringbar ist, wobei im Bereich der aufschwenkbaren Ventilatoren-Tür (44) wenigstens ein Wärmetauscher starr befestigt ist.

23. Anordnung nach einem der vorhergehenden Ansprüche,
**dadurch gekennzeichnet,**
**dass** die Ventilatoren (5), welche die mit der Verlustwärme beaufschlagte Abluft (10) aus dem Schrank (2) dem Luft-Flüssigkeit-Wärmetauscher (7) zuführen, dem Luft-Flüssigkeit-Wärmetauscher (7) nachgeschaltet sind.

## Claims

1. Arrangement for cooling electronic modular units in equipment and network cabinets, particularly server cabinets in an installation area,
having a front supply of cooling air from the environment of the cabinet (2),
an air-to-fluid heat exchanger (7) and fans (5) which are located in the vicinity of a rear of the cabinet (2) for removing the heat loss produced by the electronic modular units and which suck the exhaust air (10) supplied with the heat loss of the electronic modular units, out of the cabinet (2) and, prior to the delivery to the ambient air of the cabinet (2), pass the same through the air-to-fluid heat exchanger (7) for cooling purposes,
**characterized in that**
the fans (5) are integrated into a door and a fan door (6) is formed, which in the closed position covers an access area (8) of the rear of cabinet (2) and
that the air-to-fluid heat exchanger (7) is positioned longitudinally adjacent to the fan door (6) covering a residual area (9) of the rear of cabinet (2).

2. Arrangement according to claim 1,
**characterized in that**
the fans (5) are centrifugal fans located in the fan door (6) and that the exhaust air (10) from the cabinet (2), following a 90° deflection within the fan door (6), can be supplied to the adjacent air-to-fluid heat exchanger (7).

3. Arrangement according to claim 1 or 2,
**characterized in that**
the fan door (6) is articulated to the air-to-fluid heat exchanger (7) and can be pivoted from a closed position by up to 180° into an open position.

4. Arrangement according to one of the preceding claims,
**characterized in that**
the cooling liquid of the air-to-fluid heat exchanger (7) delivers the absorbed heat loss outside the cabinet installation area.

5. Arrangement according to one of the preceding claims,
**characterized in that**
an air-to-water heat exchanger is used as air-to-fluid heat exchanger (7).

6. Arrangement according to one of the preceding claims,
**characterized in that**
the air-to-fluid heat exchanger (7) has a pipe-fin package (12) with vertically oriented pipes (13) for the cooling liquid, particularly for cold water from the cold water supply of the building, in a heat exchanger housing (11).

7. Arrangement according to one of the preceding claims,
**characterized in that**
the fan door (6) is constructed in housing-like manner and has an inside (16) with openings (17) for the exhaust air (10) to be sucked out of the cabinet (2), an outside (18) which, at least in the vicinity of the fans (5), is positioned parallel to an inside (16), a closing side (19) and a connection side (20) parallel thereto and which is adjacent to an entrance side (21) of the heat exchanger housing (11) and, like the latter, is at least zonally perforated.

8. Arrangement according to one of the preceding claims,
**characterized in that**
the heat exchanger housing (11) has an exit side (22) facing the entrance side (21) and through which passes out the exhaust air (30) cooled to roughly ambient temperature in the air-to-fluid at exchanger (7).

9. Arrangement according to one of the preceding claims,
**characterized in that**
the fan door (6) is constructed for differently wide cabinets (2) and/or differently side rear access areas (8).

10. Arrangement according to one of the preceding claims,
**characterized in that**
the air-to-fluid heat exchanger (7) is fixed in dismantlable manner in the rear area of the cabinet (2).

11. Arrangement according to one of the preceding claims,
**characterized in that**
the air-to-fluid heat exchanger (7) is aligned with a side wall (26) of the cabinet (2) or projects over the side wall (26) of the cabinet (2).

12. Arrangement according to one of the preceding claims,
**characterized in that**
the fan door (6) can be pivoted about a vertical axis (25) with the aid of hinges (14), which are located on the outside (18) of the fan door (6) and an outer wall (23) of the heat exchanger housing (11).

13. Arrangement according to one of the preceding claims,
**characterized in that**
the pipe-fin package (12) of the air-to-fluid heat exchanger (7) are connected by connecting hoses made from a gas diffusion-tight material to the cold water supply of the building.

14. Arrangement according to one of the preceding claims,
**characterized in that**
in the fan door (6) are superimposed and/or juxtaposed several fans (5) and are fixed to the inside (16) and outside (18).

15. Arrangement according to one of the preceding claims,
**characterized in that**
the air-to-fluid heat exchanger (7) complementary to the fan door (6) extends over the height of the cabinet (2), at least over the height of the reception area (3).

16. Arrangement according to one of the preceding claims,
**characterized in that**
the fan door (6) and the air-to-fluid heat exchanger (7) are constructed as retrofitting units.

17. Arrangement according to one of the claims 1, 2, 4 to 16,
**characterized in that**
the fan door (6) is articulated to the cabinet (2) and can be pivoted by up to 180° from a closed position into an open position.

18. Arrangement according to claim 17,
**characterized in that**
the fan door (6) with a bevelled connection side (20) engages in sealed manner on an entrance side (21) of the heat exchanger housing (11).

19. Arrangement according to claim 17 or 18,
**characterized in that**
the pivot pin (25) is located on an auxiliary structure (32) of the cabinet (2).

20. Arrangement according to one of the claims 17 to 19,
**characterized in that**
the air-to-fluid heat exchanger (7) is placed in rigid manner on the rear of the cabinet (2) and the heat exchanger housing (11) can be brought about a pivot pin (35) into an open position.

21. Arrangement according to one of the claims 17 to 20,
**characterized in that**
on the rear of the cabinet (2) are provided two fan doors (40, 41) in the vicinity of which is in each case provided a heat exchanger, whereby the fan doors (40, 41) can be brought into an open position by pivot pins (25).

22. Arrangement according to one of the claims 17 to 21,
**characterized in that**
on the rear of the cabinet (2) is provided a fan door (44) extending over the entire rear and which can be brought about a pivot pin (45) into an open position and at least one heat exchanger is fixed rigidly in the vicinity of the pivotable fan door (44).

23. Arrangement according to one of the preceding claims,
**characterized in that**
the fans (5) which supply the air-to-fluid heat exchanger (7) with the exhaust air (10) supplied with heat loss from cabinet (2) are located downstream of the air-to-fluid heat exchanger (7).

## Revendications

1. Arrangement pour refroidir des unites modulaires électroniques dans des armoires d'equipments et des armoires de réseaux, notamment des armoires de serveurs dans une salle d'installation,
comportant une alimentation côté frontal d'air de refroidissement à partir de l'environnement de l'armoire (2), un échangeur de chaleur air/liquide (7) et des ventilateurs (5) installés dans la région du côté arrière de l'armoire (2) pour évacuer la chaleur dégagée par les unites modulaires électroniques et aspirant l'air d'évacuation (10) chargé de chaleur des unites modulaires électroniques de l'armoire (2) et avant d'évacuer dans l'air d'environnement de l'armoire (2), cet air est conduit dans l'échangeur de chaleur air/liquide (7) pour le réchauffer,
**caractérisé en ce que**
les ventilateurs (5) sont intégrés dans une porte et on forme une porte à ventilateurs (6) qui en position de fermeture, couvre une zone d'accès (8) du côté arrière de l'armoire (2) et
l'échangeur de chaleur air/liquide (7) est installé le long du grand côté de la porte à ventilateurs (6), de façon adjacente et en couvrant la plage résiduelle (9) du côté arrière de l'armoire (2).

2. Arrangement selon la revendication 1,
**caractérisé en ce que**
les ventilateurs (5) sont des ventilateurs radiaux, installés dans la porte à ventilateurs (6) et
l'air d'évacuation (10) alimente l'échangeur de chaleur air/liquide (7) adjacent à la porte à ventilateurs (6), pour l'air d'évacuation (10) dévié de 90° à partir de l'armoire (2).

3. Arrangement selon la revendication 1 ou 2,
**caractérisé en ce que**
la porte à ventilateurs (6) est articulée sur l'échangeur de chaleur air/liquide (7) et elle est basculée à partir d'une position de fermeture jusqu'à une position d'ouverture à 180°.

4. Arrangement selon l'une des revendications précédentes,
**caractérisé en ce que**
le liquide de refroidissement de l'échangeur air/liquide (7) évacue la chaleur dégagée reçue à l'extérieur de la salle d'installation des armoires.

5. Arrangement selon l'une des revendications précédentes,
**caractérisé en ce que**
l'échangeur de chaleur air/liquide (7) est un échangeur de chaleur air-eau.

6. Arrangement selon l'une des revendications précédentes,
**caractérisé en ce que**
l'échangeur de chaleur air/liquide (7) comporte un paquet de tubes et de lamelles (12) avec des tubes (13) dirigés verticalement pour le liquide de refroidissement, notamment pour l'eau de refroidissement d'une alimentation en eau froide de l'immeuble, dans un boîtier d'échangeur de chaleur (11).

7. Arrangement selon l'une des revendications précédentes,
**caractérisé en ce que**
la porte à ventilateurs (6) est en forme de caisson avec un côté intérieur (16) muni d'ouvertures (17) pour l'air d'évacuation (10) aspiré de l'armoire (2), un côté extérieur (18) qui est parallèle au côté intérieur (16) au moins dans la région des ventilateurs (5), un côté de fermeture (19) est parallèle à celui-ci, un côté de liaison (20) qui est adjacent au côté entrée (21) du boîtier (11) de l'échangeur de chaleur et est perforé au moins par zones comme celui-ci.

8. Arrangement selon l'une des revendications précédentes,
**caractérisé en ce que**
le boîtier d'échangeur de chaleur (11) comporte un côté de sortie (22) en regard du côté d'entrée (21) par lequel sort l'air d'évacuation (30) refroidi sensiblement à la température ambiante dans l'échangeur de chaleur air/liquide (7).

9. Arrangement selon l'une des revendications précédentes,
**caractérisé en ce que**
la porte à ventilateurs (6) est réalisée pour des armoires (2) de largeurs différentes et/ou des zones d'accès (8) côté arrière de largeurs différentes.

10. Arrangement selon l'une des revendications précédentes,
**caractérisé en ce que**
l'échangeur de chaleur air/liquide (7) est fixé de manière démontable dans la zone du côté arrière de l'armoire (2).

11. Arrangement selon l'une des revendications précédentes,
**caractérisé en ce que**
l'échangeur de chaleur air/liquide (7) est installé de façon alignée sur une paroi latérale (26) de l'armoire (2) ou en dépassant la paroi latérale (26) de l'armoire (2).

12. Arrangement selon l'une des revendications précédentes,
**caractérisé en ce que**
la porte à ventilateurs (6) est montée pivotante à l'aide de charnières (14) fixées sur le côté extérieur (18) de la porte à ventilateurs (6) et une paroi extérieure (23) du boîtier d'échangeur de chaleur (11) pour être pivotée autour d'un axe vertical (25).

13. Arrangement selon l'une des revendications précédentes,
**caractérisé en ce que**
le paquet de lamelles et de tubes (12) de l'échangeur de chaleur air/liquide (7) est relié par des tuyaux de liaison en une matière étanche à la diffusion gazeuse, avec l'alimentation en eau froide de l'immeuble.

14. Arrangement selon l'une des revendications précédentes,
**caractérisé en ce que**
la porte à ventilateurs (6) comporte plusieurs ventilateurs (5) superposés et/ou juxtaposés et fixés sur le côté intérieur et le côté extérieur (16, 18).

15. Arrangement selon l'une des revendications précédentes,
**caractérisé en ce que**
l'échangeur de chaleur air/liquide (7), comme la porte à ventilateurs (6), occupe la hauteur de l'armoire (2), au moins la hauteur du volume de réception (3) de celle-ci.

16. Arrangement selon l'une des revendications précédentes,
**caractérisé en ce que**
la porte à ventilateurs (6) et l'échangeur de chaleur air-liquide (7) sont des unités d'équipement après installation.

17. Arrangement selon l'une des revendications 1, 2, 4 à 16,
**caractérisé en ce que**
la porte à ventilateurs (6) est articulée à l'armoire (2) et peut pivoter d'une position de fermeture à une position d'ouverture sur une plage d'angle allant jusqu'à 180°.

18. Arrangement selon la revendication 17,
**caractérisé en ce que**
la porte à ventilateurs (6) est rendue étanche par un côté de liaison (20), en biais, appliqué contre le côté d'entrée (21) du boîtier d'échangeur de chaleur (11).

19. Arrangement selon la revendication 17 ou 18,
**caractérisé en ce que**
l'axe de pivotement (25) est installé sur une structure auxiliaire (32) de l'armoire (2).

20. Arrangement selon l'une des revendications 17 à 19,
**caractérisé en ce que**
l'échangeur de chaleur air/liquide (7) est installé de manière fixe au dos de l'armoire (2) et le boîtier d'échangeur de chaleur (11) peut être mis en position d'ouverture autour d'un axe de pivotement (35).

21. Arrangement selon l'une des revendications 17 à 20,
**caractérisé en ce que**
le dos de l'armoire (2) comporte deux portes à ventilateurs (40, 41) et dans la région de celles-ci il est prévu chaque fois un échangeur de chaleur, ces échangeurs pouvant être mis en position d'ouverture par des axes de basculement (25).

22. Arrangement selon l'une des revendications 17 à 21,
**caractérisé en ce que**
le dos de l'armoire (2) comporte une porte à ventilateur (44) s'étendant sur tout le dos et qui peut être mis dans une position d'ouverture en pivotant autour d'un axe d'articulation (45), et dans la région de la porte à ventilateur (44) pivotante dans le sens de l'ouverture il est fixé de manière rigide au moins un échangeur de chaleur.

23. Arrangement selon l'une des revendications précédentes,
**caractérisé en ce que**
les ventilateurs (5) qui fournissent l'air d'évacuation (10) chargé de chaleur de l'armoire (2) à l'échangeur de chaleur air-liquide (7) sont installés en aval de l'échangeur de chaleur air/liquide (7).
